Europäisches Patentamt

European Patent Office

Office européen des brevets

(19)

(11) EP 0 628 169 B1

(12) **EUROPÄISCHE PATENTSCHRIFT**

(45) Veröffentlichungstag und Bekanntmachung des Hinweises auf die Patenterteilung:
**07.05.1997 Patentblatt 1997/19**

(21) Anmeldenummer: 93903825.3

(22) Anmeldetag: **20.02.1993**

(51) Int Cl.6: **G01R 15/24**

(86) Internationale Anmeldenummer:
**PCT/DE93/00162**

(87) Internationale Veröffentlichungsnummer:
**WO 93/17346 (02.09.1993 Gazette 1993/21)**

(54) **VERFAHREN UND SENSOR ZUM MESSEN VON ELEKTRISCHEN SPANNUNGEN UND/ODER ELEKTRISCHEN FELDSTÄRKEN**

PROCESS AND SENSOR FOR MEASURING ELECTRIC VOLTAGES AND/OR ELECTRIC FIELD INTENSITIES

PROCEDE ET DETECTEUR POUR LA MESURE DE TENSIONS ELECTRIQUES ET/OU D'INTENSITES DE CHAMPS ELECTRIQUES

(84) Benannte Vertragsstaaten:
**AT BE CH DE DK ES FR GB GR IE IT LI LU MC NL PT SE**

(30) Priorität: **24.02.1992 DE 4205509**

(43) Veröffentlichungstag der Anmeldung:
**14.12.1994 Patentblatt 1994/50**

(73) Patentinhaber: **MWB High Voltage Systems GmbH**
**D-96050 Bamberg (DE)**

(72) Erfinder:
• **PEIER, Dirk**
**D-4600 Dortmund (DE)**

• **HIRSCH, Holger**
**D-4703 Bönen (DE)**

(74) Vertreter:
**Hufnagel, Walter, Dipl.-Ing., Dipl.-Wirtsch.-Ing. et al**
**Bad Brückenauer Strasse 6**
**90427 Nürnberg (DE)**

(56) Entgegenhaltungen:
| | |
|---|---|
| EP-A- 0 294 816 | DE-A- 3 924 369 |
| US-A- 4 755 036 | US-A- 5 012 183 |

**Beschreibung**

Die vorliegende Erfindung bezieht sich auf ein Verfahren zum Messen von elektrischen Spannungen oder elektrischen Feldstärken und auf einen Sensor zur Ausübung dieses Verfahrens gemäß den Oberbegriffen der Ansprüche 1, 2 und 9.

Ein derartiges Verfahren und ein hierzu geeigneter Sensor sind beispielsweise aus der DE-A-39 24 369 bekannt. Sowohl das in dieser Vorveröffentlichung beschriebene Verfahren als auch andere bekannte Verfahren und dazu eingesetzte Sensoren beruhen auf dem Prinzip der Ausnutzung des linearen elektrooptischen Effektes, den verschiedene Kristalle aufweisen. Dieses Prinzip beruht darauf, daß der Brechungskoeffizient bestimmter, für Lichtwellen durchlässiger Kristalle in Abhängigkeit von einer im Kristall erzeugten elektrischen Feldstärke veränderbar ist. Diesen sogenannten elektrooptischen Effekt zeigen beispielsweise Kristalle aus Lithiumniobat oder Kaliumhydrophosphat, deren Kristallachsen x, y und z zumindest annähernd zueinander senkrecht stehen.

Bei dem aus der DE-A-39 24 369 bekannten Verfahren wird ein stabförmiger, im Querschnitt rechteckiger Kristall aus Quarz verwendet, der auf zwei einander gegenüberliegenden Seitenflächen mit je einer Elektrode versehen ist. Die Elektroden werden an eine Spannung angelegt, so daß im Kristall ein elektrisches Feld erzeugt und dadurch der Brechungsindex des Kristalls entsprechend der anliegenden Spannung geändert wird. Diese Änderung des Brechungsindex ist entsprechend der Elektrodenanordnung über den gesamten Bereich des Kristalls gleichmäßig, d.h. über den gesamten Kristall homogen, so daß ein Gradient des Brechungsindex weder in Richtung der Lichtwelle noch quer dazu auftritt. Die polarisierte Lichtwelle wird in Längsrichtung parallel zu den Elektroden eingestrahlt. Beim Durchlaufen der Lichtwelle durch den Kristall wird deren Polarisation bereits durch die bei Quarzen übliche natürliche Zirkulardoppelbrechung verändert, wodurch die Polarisation des Lichtstrahls beeinflußt wird und an der Ausgangsseite ein schwach elliptisch polarisierter Lichtstrahl aus dem Kristall austritt. Beim Anlegen einer Wechselspannung an die Elektroden addieren bzw. subtrahieren sich feldstärkeabhängige Anteile durch die senkrecht zu den Elektroden erzeugten Feldlinien wechselnder Feldstärke. Diese bewirken eine zusätzliche induzierte lineare Doppelbrechung, wodurch eine Pendelbewegung des schwach elliptisch polarisierten Lichtstrahls um einen Winkel um seine Ruhelage auftritt. Mittels eines nachgeschalteten Analysators in Form eines Strahlteilerwürfels wird das austretende Licht in zwei zueinander senkrechte Teilstrahlen zerlegt. Bei diesem Verfahren tritt also keine Ablenkung durch eine Inhomogenität des Brechungsindex des Kristalls auf. Die beiden über den Analysator erhaltenen Teilstrahlen werden dazu benutzt, temperaturabhängige Änderungen zu beseitigen. Die gesamte bekannte Anordnung dient also zur Temperaturkompensation von Sensoren, die einen elektrooptischen Kristall aufweisen. Dabei wird von der an sich bekannten Ablenkung eines Lichtstrahls in einem Kristall durch einen einen Gradienten aufweisenden Brechungsindex kein Gebrauch gemacht. Ein solcher ist dort vermutlich sogar unerwünscht.

Bei dem aus der EP-A-0 294 816 bekannten Stand der Technik ist ein aus elektrooptischem Material bestehendes Prisma, das keinerlei Elektroden aufweist, einem elektrischen Feld ausgesetzt. Durch das Prisma wird eine Lichtwelle hindurchgeleitet und die Änderung der Breite der austretenden Lichtwelle infolge des anliegenden Feldes gemessen. Hierbei wird der Kristall beim Einbringen in ein elektrisches Feld homogen verändert, d.h., daß sein Brechungsindex sich zwar ändert, jedoch jeweils an allen Stellen den gleichen Wert annimmt. Es sind hier weder Elektroden vorgesehen, noch tritt ein Gradient des Brechungsindex auf, der zur Messung ausgenutzt wird.

Aus der EP-A-0 294 816 ist auch eine eine elektrooptische Auslenkeinheit bildende Anordnung bekannt, bei der alle Elektroden ohne Ausnahme auf der gleichen Oberfläche eines elektrooptischen Körpers angebracht sind, und zwar auf einem auf dieser Oberfläche vorher durch Diffusion erzeugten Lichtwellenleiter. Über ein Meßverfahren oder eine Gradientenbildung des Brechungsindex sind keinerlei Hinweise gegeben.

Aus der US-A-4,755,036 ist eine elektrooptische Anordnung bekannt, die eine Ablenkeinheit für einen Lichtstrahl bildet. Dort sind auf dem elektrooptischen Kristall Lichtleiter dadurch gebildet, daß Metall, insbesondere Titan, in Form der gewünschten Strahlengänge in die eine Oberfläche des Kristalls eindiffundiert werden. Auf der gleichen Oberfläche sind Elektroden angebracht, die zur Streuung oder Konzentration der Lichtstrahlen dienen, um Sammellinsen oder Streulinsen zu bilden. Hierzu sind paarweise angeordnete, parallel zueinander verlaufende Elektroden vorgesehen, durch die die optischen Linsensysteme nachgebildet werden. Dies beruht auf der Wirkung der Elektroden, daß je nach Diffusionstiefe des Metalls quer zur Längserstreckung ein entsprechender Gradient des Brechungsindex des Kristalls, und zwar entlang der Elektrodenstreifen gemäß der Diffusion homogen und quer dazu in unterschiedlicher Größe auftritt. Auf eine mögliche Gradientenbildung des Brechungsindex durch beidseitig angebrachte Elektroden und deren Schaltung in der erfindungsgemäßen Weise sowie deren Anwendung zur Messung einer Spannung oder elektrischen Feldstärke sind keine Hinweise zu finden.

Weiterhin ist aus der US-A-5,012,183 eine Elektrodenanordnung aus vier Elektroden auf einem elektrooptischen Kristall bekannt. Die Flächen der Elektroden liegen hier in der Ebene der y-z-Achse des Kristalls und der Lichtstrahl wird senkrecht zu den Elektroden entweder in z-Richtung oder in x-Richtung in den Kristall eingestrahlt. Die vier Elektroden sind paarweise einander gegenüberliegend angeordnet. Das eine Paar der einen Oberfläche wird an eine zu messende Spannung angelegt. Hierbei tritt ein Gradient des Brechungsindex in Richtung seiner z-Achse auf. Durch Einkoppeln des Lichts senkrecht zu den Elektroden tritt eine Verzerrung des Lichtstrahls ein, die durch Anlegen einer Kompensationsspannung an das andere Elektrodenpaar auf der anderen Oberfläche des Kristalls aufgehoben wird. Aus der Größe der Kompensationsspannung kann die Größe der zu messenden Spannung ermittelt werden. Durch eine spezielle Meß- und Steuereinrichtung wird eine Temperaturkompensation durchgeführt.

Zur Ermittlung der Brechungsindizes sind interferometrische Anordnungen oder polarimetrische Anordnungen bekannt. Bei ersterem Verfahren wird die Phase einer Lichtwelle moduliert und einer Referenzwelle überlagert, was zu einer Intensitätsänderung der ausgekoppelten Lichtwelle führt. Bei der polarimetrischen Anordnung wird die Polarisation einer polarisierten Lichtwelle in Abhängigkeit vom Brechungsindex verändert und die Intensitätsänderung durch einen Polarisator festgestellt.

Beide bekannte Anordnungen benötigen einen relativ hohen technischen Aufwand. Außerdem ergeben sich Realisierungsprobleme durch die zu verwendenden Materialien. Außer der Forderung nach hohen elektrooptischen Effekten der Materialien treten bei diesen neben dem reinen elektrooptischen Effekt jeweils noch sowohl der piezoelektrische als auch der elastooptische Effekt auf, die zusammen das gleiche Erscheinungsbild wie der reine elektrooptische Effekt zeigen. Die Trägheit des Materials führt dann dazu, daß sich im Bereich niedriger Frequenzen der elektrooptische Effekt einerseits und der piezoelektrische und elastooptische Effekt andererseits einander überlagern. Der Übergangsbereich ist weiterhin durch Resonanzerscheinungen gekennzeichnet, die aus Kristallschwingungen resultieren.

Für ein breitbandiges Meßsystem muß folglich die ausschließliche Nutzung des reinen elektrooptischen Effekts gefordert werden, d.h., die entsprechenden piezoelektrischen/elastooptischen Effekte müssen vernachlässigbar sein.

Bei der polarimetrischen Anordnung muß dieser Sachverhalt gleichzeitig für zwei Koeffizienten erfüllt sein, während bei einer interferometrischen Anordnung ein Koeffizient ausreicht. Demzufolge stehen sehr viel mehr Materialien zum Aufbau eines breitbandigen interferometrischen Meßsystems zur Verfügung als für ein breitbandiges polarimetrisches Meßsystem. Dem steht jedoch der erhebliche Technologieaufwand eines Interferometers gegenüber. Hierzu müssen ferner integriert-optische Bauelemente verwendet werden, denen die optische Leistung mit einem definierten Mode sowie mit einem definierten Polarisationszustand zugeführt werden müssen. Beim praktischen Einsatz dieser Technologie ist daher die Verwendung eines polarisationserhaltenden Lichtwellenleiters (HiBi-Faser) zwingend erforderlich.

Mit der Erfindung soll die Aufgabe gelöst werden, ein Verfahren und einen Sensor zur Ausübung dieses Verfahrens vorzuschlagen, mit dem bzw. mit denen die Vorteile des interferometrischen Verfahrens grundsätzlich beibehalten werden können, nämlich die Notwendigkeit der Auswertung nur eines einzigen elektrooptischen Koeffizienten. Außerdem soll der technische Aufwand dadurch klein gehalten werden, daß weder eine integriert-optische Technologie zum Einsatz kommen soll, noch spezielle Lichtwellenleiter verwendet werden müssen.

Gelöst wird diese Aufgabe durch die in den Ansprüchen 1 bzw. 2 bzw. 9 angegebenen Merkmale.

Die Erfindung zeichnet sich insbesondere dadurch aus, daß die Lichtwelle lediglich durch den Kristall hindurchgeschickt, also ein- und ausgekoppelt werden muß. Die Auslenkung der auszukoppelnden bzw. ausgekoppelten Lichtwelle ist mit einfachen Mitteln feststellbar und auswertbar.

Weitere vorteilhafte Einzelheiten der Erfindung sind in den Unteransprüchen angegeben und werden nachfolgend anhand der in der Zeichnung veranschaulichten Ausführungsbeispiele näher beschrieben. Es zeigen:

Fig. 1     eine perspektivische Ansicht eines erfindungsgemäß eingesetzten, an Spannung liegenden Kristalls,

Fig. 2     eine Draufsicht auf den Kristall gemäß Fig. 1 und

Fig. 3     eine Ansicht der Stirnseite des Kristalls gemäß Fig. 1,

Fig. 4     den Verlauf des Brechungsindex n in der x-Richtung,

Fig. 5     den Verlauf der Feldstärke $E_z$ in der x-Richtung,

Fig. 6     den möglichen Verlauf einer ausgelenkten Lichtwelle und

Fig. 7     die Anordnung eines Sensors zwischen zwei in einem elektrischen Feld vorgesehenen Kugelhalbschalen.

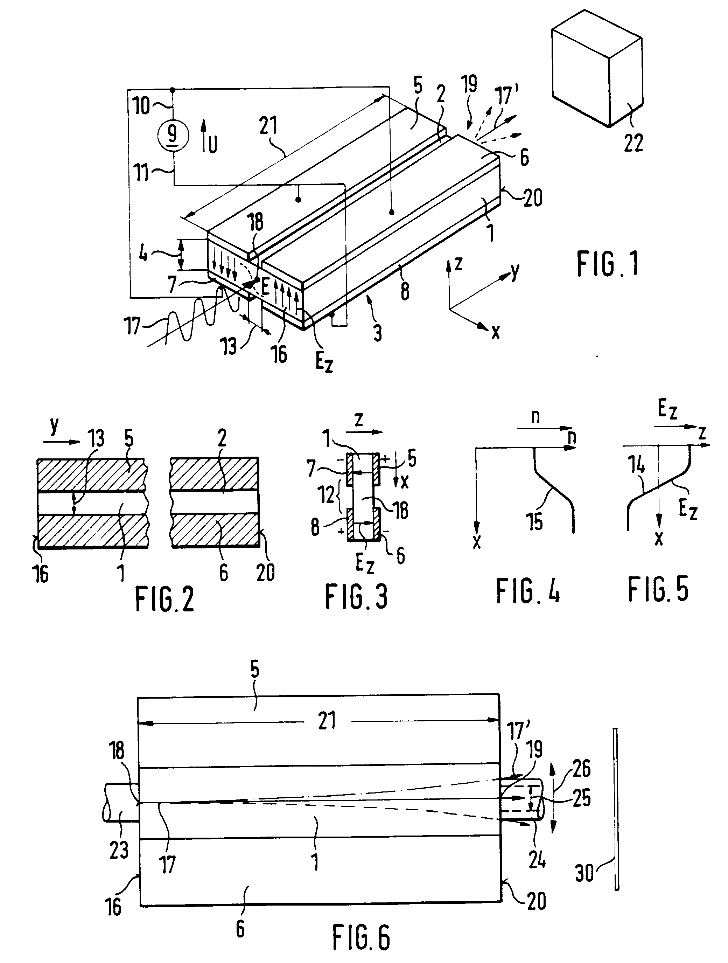

In Fig. 1 ist mit 1 ein Kristall, beispielsweise aus Lithiumniobat bezeichnet. Seine beiden Flächen - Oberseite 2 und Unterseite 3 - verlaufen in der Richtung der x- und y-Achsen und dessen Dicke 4 in Richtung der z-Achse des Kristalls 1, wie dies anhand des Koordinatensystems dargestellt ist. Nachfolgend beziehen sich die Koordinatenangaben der x-, y- und z-Richtung stets auf die Kristallachsen. Beide Flächen 2 und 3 sind jeweils mit einem Paar sich in der y-Richtung erstreckenden, streifenförmigen Elektroden 5, 6 bzw. 7, 8 versehen. Dabei steht das eine Elektrodenpaar 5, 6 dem anderen Elektrodenpaar 7, 8 deckungsgleich gegenüber. Beide Elektrodenpaare 5, 6 bzw. 7, 8 sind an eine Spannungsquelle 9 angeschlossen, indem jeweils die diagonal einander gegenüberstehenden Elektroden 5, 8 und 6, 7 gemeinsam mit je einem der Pole 10 bzw. 11 derselben verbunden sind. Hierdurch bildet sich zwischen den Elektroden 5 und 7 einerseits und zwischen den Elektroden 6 und 8 andererseits ein elektrisches Feld $E_z$ in der z-Richtung aus; jedoch sind diese elektrischen Felder $E_z$ entsprechend der Anschaltung an die Spannungsquelle 9 einander entgegengerichtet. Infolge der Definition des linearen elektrooptischen Effekts wird daher beispielsweise der Brechungsindex n des Kristalls 1 im einen Fall vergrößert und im anderen Fall verkleinert (sogenannter Pockels-Effekt).

Entsprechend bildet sich im Bereich 12, der in der Regel etwas größer ist als der Abstand 13 zwischen den parallel zueinander verlaufenden Elektroden 5, 6 und 7, 8 jeweils in einer Fläche 2 bzw. 3 gemäß Fig. 4 eine kontinuierlich sich ändernde Feldstärke mit bestimmten Feldstärkegradienten 14 in der x-Richtung aus. Entsprechend ändert sich auch der Brechungskoeffizient n in der x-Richtung und man erhält einen entsprechenden Gradienten 15, wie anhand der Fig. 4 dargestellt ist.

Eine der senkrecht zur y-Richtung stehenden Stirnflächen 16 dient zum Einkoppeln einer in der z-Richtung polarisierten Lichtwelle 17. Die Einkoppelstelle 18 ist im Ausführungsbeispiel mittig zur Stirnfläche 16 gewählt. Entsprechend kann die Auskoppelstelle 19 auf der anderen Stirnfläche 20 vorgesehen sein. Je nach dem gewünschten Meßergebnis können diese Ein- und Auskoppelstellen 18, 19 jedoch auch an anderen Stellen des Kristalls 1 gewählt bzw. vorgesehen sein.

Eine Spannungs- bzw. Feldmessung mit der vorgenannten Anordnung kann folgendermaßen durchgeführt werden:

Bei der Ausbreitung der in z-Richtung polarisierten Lichtwelle 17 in positiver y-Richtung des Kristalls 1 tritt die Brechzahl n mit dem einen elektrooptischen Koeffizienten $r_{33}$ (einziger in guter Annäherung frequenzunabhängiger Koeffizient von Lithiumniobat):

$$n = n_e - 1/2\, n_e^3 r_{33} E_z \qquad (1)$$

in Erscheinung, wobei $n_e$ = 2,200 die extraordentliche Brechzahl und $E_z$ das äußere elektrische Feld entlang der z-Richtung des Kristalls beschreibt.

Verändert sich die Feldstärkenkomponente $E_z$ entlang der Koordinate x, so ist auch die Brechzahl eine Funktion des Ortes. Die Lichtausbreitung der in der y-Richtung eingestrahlten Lichtwelle 17 läßt sich dann beschreiben durch die Eikonalgleichung:

$$|grad\ \Phi(x)|^2 = n(x)^2 \qquad (2)$$

mit der Phasenfunktion $\Phi$ (x) der optischen Welle. Die Lichtwelle folgt damit der Strahlengleichung

$$d/ds(n(x)\cdot dr/ds) = grad\ n(x) \qquad (3)$$

mit der Weglänge s entlang der Lichtstrecke bzw. Strahlenausbreitung und dem Ortsvektor r. Eine mögliche Auslenkung der Lichtwelle 17 ist in der Fig. 6 gestrichelt bzw. strichpunktiert dargestellt.

Aus der Lösung der Gleichung (3) folgt für die Ortsfunktion des Lichtstrahls näherungsweise

$$x = 1/\alpha\cdot(cosh(\alpha y)-1) \qquad (4)$$

$$\alpha = -1/2\, n_e^2 r_{33}\, dE_z\, (x)/dx \qquad (5)$$

Kleine Ablenkwinkel $\varphi$ lassen sich unter Berücksichtigung der Berechnung beim Austritt der Lichtwelle 17' aus dem Kristall 1 mit der durchstrahlten Lichtstrecke 21 bzw. Länge L abschätzen zu:

$$\varphi = -1/2\, n_e^3 r_{33}\, dE_z\, (x)/dx\, L \qquad (6)$$

Anhand der Gleichung (6) wird deutlich, daß für die elektrooptische Auslenkung der Lichtwelle 17 der Gradient der Feldstärke $E_z$ maßgebend ist. Ein derartiger Feldstärkeverlauf wird durch die beschriebene Vier-Elektroden-Anordnung realisierbar.

Durch geeignete Einkopplung und Auskopplung der Lichtwelle 17 kann ein entsprechend dem zeitlichen Feldstärkeverlauf, beispielsweise ein intensitätsmoduliertes optisches Signal an einer Auswerteeinheit 22 erhalten werden, das der an den Elektroden 5, 6 bzw. 7, 8 angelegten Spannung bzw. einer entsprechenden Feldstärke entspricht.

Die Einkopplung der Lichtwelle 17 kann, wie in Fig. 6 angedeutet, über einen an die Stirnfläche 16 angekoppelten geeigneten Lichtwellenleiter 23 und die Auskopplung über einen an die Stirnfläche 20 angekoppelten Lichtwellenleiter 24 erfolgen. Bevorzugt ist der Kern oder Kerndurchmesser 25 des an der Auskoppelseite vorgesehenen Lichtwellenleiters 24 kleiner als der mögliche Auslenkbereich 26. Hierdurch kann bei der dargestellten zentrierten Anordnung des Lichtwellenleiters 24 zum Lichtwellenleiter 23 die Auslenkung durch eine Intensitätsänderung der in den Lichtwellenleiter 24 eingestrahlten Lichtleistung erkannt werden.

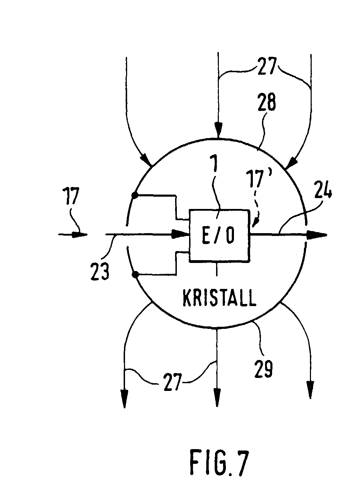

Zur Messung eines elektrischen Feldes kann gemäß Fig. 7 in das Feld 27 eine Anordnung aus zwei, beim Ausführungsbeispiel als Kugelhalbschalen ausgebildeten, Potentialflächen 28 und 29 aus zumindest einseitig elektrisch leitfähigem Werkstoff angebracht werden, zwischen denen der - wie beschrieben - ausgeführte Kristall 1 angeordnet ist. Die Elektroden sind anstelle einer Spannungsquelle 9 mit den Potentialflächen 28, 29 verbunden. Bei vorhandenem elektrischem Feld 27 wird auf den Potentialflächen 28, 29 eine elektrische Spannung induziert, die ein Maß für die dort vorhandene Feldstärke darstellt und gemessen werden kann. Bei dieser Meßanordnung und Meßmethode ist daher der Sensor nicht an eine externe Spannung oder Spannungsversorgung angeschlossen, so daß die ansonsten dadurch bedingten Feldverzerrungen nicht mehr auftreten können.

Die Auswertung der Auslenkung der ausgekoppelten oder auszukoppelnden Lichtwelle 17' erfolgt mit Vorteil über eine Fotodiode oder über eine Diodenzeile oder über sonstige Fotoelemente, ggf. über eine Blende 30, wie in Fig. 6 dargestellt ist.

Das erfindungsgemäße Verfahren und der hierbei zur Anwendung gelangende erfindungsgemäße Sensor können für Gleichstrom oder für nieder- und hochfrequente Spannungen oder auch für entsprechende Gleich- oder Wechselfelder verwendet werden.

Wie sich aus der Beschreibung der Figur 1 ergibt, sind das erfindungsgemäße Verfahren und der Sensor zur Ausübung dieses Verfahrens auch dann vollständig funktionsfähig, wenn die Kristallachsen x und y um 90° gegenüber der zeichnerischen Darstellung in Figur 1 gedreht werden.

## Patentansprüche

1. Verfahren zum Messen von elektrischen Spannungen unter Verwendung des bei einem Kristall (1) auftretenden elektrooptischen Effekts, indem eine polarisierte Lichtwelle (17) durch den Kristall (1) hindurchgeleitet wird und entlang der Lichtstrecke (21) die Feldstärke im Kristall (1) und damit der Brechungsindex des Kristalls (1) mittels auf einander gegenüberliegenden Oberflächen des Kristalls (1) parallel zur Lichtstrecke (21) verlaufender, an eine zu messende Spannung (9;10,11) angelegter Elektroden (5,6;7,8) entsprechend der an diesen Elektroden (5,6;7,8) anliegenden Spannung verändert wird und die durch Veränderung des Brechungsindex erzeugte Veränderung der Lichtwelle (17) als Maß für die an die Elektroden (5,6;7,8) angelegte Spannung verwendet wird, dadurch gekennzeichnet, daß die an die zu messende Spannung (9; 10, 11) angeschlossenen Elektroden (5,6;7,8) in zu der durch die x- und y-Achse des Kristalls (1) aufgespannten Ebene parallelen Ebenen derart angebracht werden, daß bei anliegender Spannung (9; 10, 11) im Kristall (1) entlang der Lichtstrecke (21) ein zur Ausbreitungsrichtung der Lichtwelle (17), die in Richtung der x-Achse oder der y-Achse des Kristalls (1) verläuft, quer verlaufender, in Richtung der z-Achse des Kristalls (1) gerichteter Gradient der elektrischen Feldstärke ($E_z$), und damit ein Gradient des Brechungsindex (n) auftritt, und daß durch den auftretenden Gradienten die Lichtwelle (17) im Kristall (1) spannungsabhängig in y-Richtung bzw. in x-Richtung ausgelenkt und diese Auslenkung zur Bestimmung der zu messenden, an den Elektroden (5,6;7,8) anliegenden Spannung verwendet wird.

2. Verfahren zum Ermitteln von elektrischen Feldstärken unter Verwendung des bei einem Kristall (1) auftretenden elektrooptischen Effekts, indem eine polarisierte Lichtwelle (17) durch den Kristall (1) hindurchgeleitet wird und entlang der Lichtstrecke (21) die Feldstärke im Kristall (1) und damit der Brechungsindex des Kristalls (1) mittels auf einander gegenüberliegenden Oberflächen des Kristalls (1) parallel zur Lichtstrecke (21) verlaufender, an jeweils ein Potential (28,29) angelegter Elektroden (5,6;7,8) entsprechend der an diesen Elektroden (5,6;7,8) anliegenden zumessenden Potentialdifferenz verändert wird und die durch Veränderung des Brechungsindex erzeugte Veränderung der Lichtwelle (17) als Maß für die an die Elektroden (5,6; 7,8) angelegte Potential differenz verwendet wird, dadurch gekennzeichnet, daß die an die zu messende Potential differenz angeschlossenen Elektroden (5,6;7,8) in zu der durch die x- und y-Achse des Kristalls (1) aufgespannten Ebene parallelen Ebenen derart angebracht werden, daß bei anliegender Potential differenz im Kristall (1) entlang der Lichtstrecke (21) ein zur Ausbreitungsrichtung der Lichtwelle (17), die in Richtung der x-Achse oder der y-Achse des Kristalls (1) verläuft, quer verlaufender, in Richtung der z-Achse des Kristalls (1) gerichteter Gradient der elektrischen Feldstärke ($E_z$), und damit ein Gradient des Brechungsindex (n) auftritt, und daß durch den auftretenden Gradienten die Lichtwelle (17) im Kristall (1) potential differenzabhängig in y-Richtung bzw. in x-Richtung ausgelenkt und diese Auslenkung zur Bestimmung der zu messenden, an den Elektroden (5,6;7,8) anliegenden Potential differenz verwendet wird.

3. Verfahren nach Anspruch 1 oder 2, dadurch gekennzeichnet, daß ein plättchenförmiger Kristall (1) verwendet wird, dessen Plattenflächen (2,3) in zu der durch die x- und y-Kristallachsen aufgespannten Ebene parallelen Ebenen verläufen dessen Dikke in z-Richtung der Kristallachsen (x,y,z) verläuft und auf dessen Platennflächen (2,3) im Abstand (13) voneinander verlaufende Elektroden (5,6;7,8) angebracht sind und die jeweils einander diagonal gegenüberliegenden Elektroden (5,8;6,7) miteinander verbunden sind, daß an diese Elektroden (5,8; 6,7) die zu messende Spannung bzw. die zu messende Potential differenz gelegt wird, und daß die Lichtwelle (17) an einer Stirnseite (16) des Kristalls (1) an einer sich im Bereich (12) des Abstandes (13) befindlichen Stelle (18) in y-Richtung bzw. in x-Richtung eingestrahlt und an der gegenüberliegenden Stirnseite (20) ausgekoppelt wird.

4. Verfahren nach einem der Ansprüche 1 bis 3, dadurch gekennzeichnet, daß eine in Richtung der z-Achse des Kristalls (1) polarisierte Lichtwelle (17) verwendet wird.

5. Verfahren nach einem der Ansprüche 1 bis 4, dadurch gekennzeichnet, daß die Lichtwelle (17) über einen Lichtwellenleiter (23) eingekoppelt wird.

6. Verfahren nach einem der Ansprüche 1 bis 5, dadurch gekennzeichnet, daß die Auskopplung der ausgelenkten Lichtwelle (17') an der der Einkopplungs-Stirnseite (16) gegenüberliegenden Stirnseite (20) über einen Lichtwellenleiter (24) erfolgt, dessen lichtleitender Kern (25) kleiner ist als der Auslenkbereich (26) der auszukoppelnden Lichtwelle (17), so daß die Auslenkung eine Änderung der Lichtintensität der ausgekoppelten Lichtwelle (17') bewirkt.

7. Verfahren nach einem der Ansprüche 2 bis 6, dadurch gekennzeichnet, daß in ein zu messendes elektrisches Feld (27) zwei Potentialflächen (28,29) im Abstand voneinander eingebracht werden, daß der Kristall (1) zwischen diesen angeordnet wird und daß die Potentialflächen (28,29) an die Elektroden (5,6;7,8) angeschlossen werden.

8. Verfahren nach Anspruch 7, dadurch gekennzeichnet, daß als Potentialflächen Kugelsonden oder Halbkugelsonden (28,29) verwendet werden.

9. Sensor zur Durchführung des Verfahrens nach einem der Ansprüche 1 bis 8, bestehend aus einem plättchenförmigen Kristall (1), dessen zueinander parallele Plattenflächen (2, 3) sich in zu der durch die x- und y-Kristallachsen aufgespannten Ebene parallelen Ebenen erstrecken und dessen Dicke sich senkrecht zu dieser Ebene in Richtung der z-Kristallachse erstreckt, wobei auf den Plattenflächen (2, 3) einander gegenüberliegende Elektroden vorgesehen sind und die in y- bzw. x-Richtung vorhandenen, jeweils einander gegenüberliegenden Stirnflächen (16, 20) des Kristalls (1) als Ein- bzw. Auskoppelstelle für die Lichtwelle dienen, dadurch gekennzeichnet, daß auf jeder Plattenfläche (2, 3) die Elektroden (5, 6; 7, 8) je eines der Elektrodenpaare (5,6;7,8) in y- oder x-Richtung streifenförmig, parallel zueinander und im Abstand (13) voneinander derart angeordnet sind, daß jeweils ein Paar (5, 6) dieser Elektroden dem anderen Paar (7, 8) dieser Elektroden gegenüberliegt, und daß jeweils die einander diagonal gegenüberliegenden Elektroden (5, 8; 6, 7) miteinander leitend verbunden sind.

10. Sensor nach Anspruch 9, dadurch gekennzeichnet, daß der Kristall (1) aus Lithiumniobat besteht.

**Claims**

1. A method of measuring electric voltages by employment of the electrooptical effect which occurs in a crystal (1), in which a polarized lightwave (17) is passed through the crystal (1) and by means of electrodes (5,6;7,8) which run along opposite surfaces of the crystal (1) in parallel with the path (21) of the light and are energized at a voltage (9;10,11) which is to be measured, the field strength in the crystal (1) along the path (21) of the light and thereby the refractive index of the crystal (1) is altered to correspond with the voltage applied to these electrodes (5,6;7,8), and the alteration of the lightwave (17) generated by alteration of the refractive index is employed as a measure of the voltage applied to the electrodes (5,6;7,8), characterized in that the electrodes (5,6;7,8) connected to the voltage (9; 10,11) which is to be measured, are fitted in planes parallel with the plane extending through the x- and y-axes of the crystal (1), in such a way that with voltage (9;10,11) applied a gradient of the electric field strength ($E_z$) occurs in the crystal (1) along the path (21) of the ligth, directed in the direction of the z-axis of the crystal (1) to run across the direction of propagation of the lightwave (17), which runs in the direction of the x- axis or y-axis of the crystal (1), and a gradient of the refractive index (n) thereby occurs, and that through the gradient which arises the lightwave (17) is deflected in the crystal (1) in the y-direction or the x-direction in dependence upon the voltage, and this deflection is employed for determination of the voltage to be measured, which is applied to the electrodes (5,6;7,8).

2. A method of determining electric field strengths by employment of the eletrooptical effect which occurs in a crystal (1), in which a polarized lightwave (17) is passed through the crystal (1) and by means of electrodes (5,6;7,8) which run along opposite surfaces of the crystal (1) in parallel with the path (21) of the light and are energized at respective potentials (28,29), the field strength in the crystal (1) along the path (21) of the light and thereby the refractive index of the crystal (1) is altered to correspond with the potential difference which is to be measured, applied to these electrodes (5,6;7,8), and the alteration of the lightwave (17) generated by alteration of the refractive index is employed as a measure of the potential difference applied to the electrodes (5,6;7,8), characterized in that the electrodes (5,6;7,8) connected to the potential difference which is to be measured, are fitted in planes parallel with the plane extending through the x- and y-axes of the crystal (1), in such a way that with potential difference applied a gradient of the electric field strength ($E_z$) occurs in the crystal (1) along the path (21) of the light, directed in the direction of the z-axis of the crystal (1) to run across the direction of propagation of the lightwave (17), which runs in the direction of the x-axis or y-axis of the crystal (1), and a gradient of the refractive index (n) thereby occurs, and that through the gradient which arises the lightwave (17) is deflected in the crystal (1) in the y-direction or the x-direction in dependence upon the potential difference, and this deflection is employed for determination of the potential difference which, being applied to the electrodes (5,6;7,8), is to be measured.

3. A method as in Claim 1 or 2, characterized in that the crystal (1) employed has the shape of a platelet of which the main faces (2,3) run in planes parallel with the plane extending through the x- and y-axes of the crystal (1) and the thickness runs in the z-direction of the axes (x,y,z) of the crystal (1), and electrodes (5,6;7,8) running at a distance (13) apart are fitted to its main faces (2,3), the electrodes (5,8; 6,7) which lie diagonally opposite one another being connected together in pairs, that the voltage or potential difference which is to be measured is applied to these electrodes (5,8;6,7), and that the lightwave (17) is beamed in the y-direction or x-direction into one endface (16) of the crystal (1) at a point (18) lying in the range (12) of the distance (13), and decoupled at the opposite endface (20).

4. A method as in one of the Claims 1 to 3, characterized in that a lightwave (17) is employed which is polarized in the direction of the z-axis of the crystal (1).

5. A method as in one of the Claims 1 to 4, characterized in that the lightwave (17) is input via a lightwave guide (23).

6. A method as in one of the Claims 1 to 5, characterized in that the decoupling of the deflected lightwave (17') is effected at the endface (20) opposite the input endface (16) via a lightwave guide (24) the light-conductive core (25) of which is smaller than the range (26) of deflection of the lightwave (17) to be decoupled, so that the deflection brings about an alteration in the intensity of the light in the decoupled lightwave (17').

7. A method as in one of the Claims 2 to 6, characterized in that into an electric field (27), which is to be measured, two potential areas (28,29) are introduced at a distance apart, that the crystal (1) is arranged between them and that the potential areas (28,29) are connected to the electrodes (5,6;7,8).

8. A method as in Claim 7, characterized in that spherical probes or hemispherical probes (28,29) are employed as potential areas.

9. A sensor for the performance of the method as in one of the Claims 1 to 8, consisting of a crystal (1) in the shape of a platelet of which the parallel main faces (2,3) extend in planes parallel with the plane extending through the x- and y-axes of the crystal (1) and the thickness extends perpendicularly to this plane in the direction of the z-axis of the crystal (1), electrodes lying opposite one another being provided on the main faces (2,3) and in the y-or x-direction existing opposite endfaces (16,20) of the crystal (1) serving respectively as input and decoupling points for the lightwave (17), characterized in that upon each main face (2,3) the electrodes (5,6; 7,8) of each pair of electrodes (5,6;7,8) are arranged in the y- or x-direction in the form of parallel strips at a distance (13) apart, in such a way that any one pair (5,6) of these electrodes lies opposite the other pair (7,8) of these electrodes, and that the electrodes (5,8;6,7) which lie diagonally opposite one another are respectively connected together conductively.

10. A sensor as in Claim 9, characterized in that the crystal (1) consists of lithium niobate.

**Revendications**

1. Procédé pour mesurer les tensions électriques en utilisant l'effet électro-optique produit dans un cristal (1), selon lequel on fait passer une onde lumineuse polarisée (17) à travers le cristal (1) et on modifie le long du chemin optique (21) l'intensité du champ dans le cristal (1) et ainsi l'indice de réfraction du cristal (1) à l'aide d'électrodes (5, 6 ; 7, 8) sur les surfaces superficielles opposées du cristal (1), parallèles aux chemins optiques (21), électrodes auxquelles est appliquée une tension à mesurer (9; 10, 11), cette variation se faisant en fonction de la tension appliquée à ces électrodes (5, 6; 7, 8), et la variation de l'onde lumineuse (17) créée par la variation de l'indice de réfraction est utilisée comme mesure de la tension appliquée aux électrodes (5, 6; 7, 8),

caractérisé en ce que

les électrodes (5, 6; 7, 8) reliées à la tension (9; 10, 11) à mesurer sont prévues dans des plans parallèles au plan passant par les axes x et y du cristal (1) de façon que lorsqu'une tension (9; 10, 11) est appliquée, dans le cristal (1), le long du chemin optique (21), on obtient un gradient du champ électrique $(E_z)$ qui est transversal à la direction d'étalement de l'onde optique (17) qui passe dans la direction de l'axe x ou de l'axe y du cristal (1), suivant la direction de l'axe z du cristal (1), et donnant ainsi un gradient pour l'indice de réfraction (n) et

les gradients produits dévient l'onde optique (17) dans le cristal (1) en fonction de la tension dans la direction y ou dans la direction x et cette déviation est utilisée pour déterminer la tension à mesurer, appliquée aux électrodes (5, 6; 7, 8).

2. Procédé pour déterminer des champs électriques en utilisant l'effet opto-électronique produit dans un cristal traversé par une onde lumineuse polarisée (17), et le long du chemin optique (21) on modifie l'intensité du champ dans le cristal (1) et ainsi l'indice de réfraction du cristal (1) à l'aide d'électrodes (5, 6; 7, 8) reliées à un potentiel respectif (28, 29), en regard des surfaces opposées du cristal (1), parallèlement au chemin optique (21) et correspondant à la différence de potentiel à mesurer appliquée à ces électrodes (5, 6; 7, 8), et on utilise la variation de l'onde lumineuse (17) produite par la variation de l'indice de réfraction comme mesure de la différence de tension appliquée aux électrodes (5, 6; 7, 8),
caractérisé en ce que

les électrodes (5, 6 ; 7, 8), reliées à la différence de potentiel à mesurer, sont prévues dans des plans parallèles au plan défini par les axes x et y du cristal (1), de façon que lorsqu'une différence de potentiel est appliquée, dans le cristal (1), le long du chemin optique (21), il y a une intensité de champ électrique ($E_z$) dirigée transversalement à la direction d'extension de l'onde lumineuse (17) qui correspond à la direction de l'axe x ou de l'axe y du cristal (1), ce champ électrique étant dirigé suivant l'axe (z) du cristal (1) ce qui donne un gradient pour l'indice de réfraction (n), et
les gradients produits dévient l'onde optique (17) dans le cristal (1) en fonction de la différence de potentiel, dans la direction (y) ou dans la direction (x) et cette déviation est utilisée pour déterminer la différence de potentiel à mesurer, appliquée aux électrodes (5, 6; 7, 8).

3. Procédé selon la revendication 1 ou 2, caractérisé en ce qu'

on utilise un cristal (1) en forme de plaquette dont les surfaces de plaquette (2, 3) sont dans des plans parallèles au plan passant par les axes (x) et (y) du cristal, et dont l'épaisseur correspond à la direction (z) des axes (x, y, z) du cristal, et sur ces plaquettes (2, 3), il y a des électrodes (5, 6 ; 7, 8) écartées de la distance (13), et les électrodes (5, 8;6, 7) chaque fois opposées en diagonale sont reliées,
la tension à mesurer ou la différence de potentiel à mesurer est appliquée à ces électrodes (5, 8;6, 7) et

l'onde lumineuse (17) est injectée dans la direction (y) ou dans la direction (x), au point (18) qui se trouve au niveau (12) de l'écart (13) et cette lumière est découplée par la face frontale (20), opposée.

4. Procédé selon l'une des revendications 1 à 3, caractérisé en ce qu'
on utilise une onde lumineuse (17) polarisée dans la direction de l'axe z du cristal (1).

5. Procédé selon l'une des revendications 1 à 4, caractérisé en ce qu'
on injecte l'onde lumineuse (17) par un guide d'ondes lumineuses (23).

6. Procédé selon l'une des revendications 1 à 5, caractérisé en ce que
le découplage de l'onde lumineuse déviée (17') se fait sur la face frontale (20) opposée à la face frontale d'injection (16) par un guide d'ondes lumineuses (24) dont le noyau conducteur de lumière (25) est inférieur à la zone de déflexion (26) de l'onde lumineuse (17) à découpler pour que la déflexion produise une variation de l'intensité lumineuse de l'onde lumineuse découplée (17').

7. Procédé selon l'une des revendications 2 à 6, caractérisé en ce que
dans le champ électrique à mesurer (27) on prévoit deux surfaces de potentiel (28, 29) distantes l'une de l'autre, on place le cristal (1) entre celles-ci et on branche les surfaces de potentiel (28, 29) aux électrodes (5, 6; 7, 8).

8. Procédé selon la revendication 7, caractérisé en ce qu'
on utilise des sondes sphériques comme surfaces de potentiel ou des ondes hémisphériques (28, 29).

9. Capteur pour la mise en oeuvre du procédé, selon l'une des revendications 1 à 8, composé d'un cristal (1) en forme de plaquette dont les surfaces de plaquette (2, 3), parallèles s'étendent dans des plans parallèles par rapport au plan passant par les axes x et y du cristal et dont l'épaisseur prise perpendiculairement à ce plan correspond à la direction z du cristal, et sur les surfaces (2, 3) de la plaquette on prévoit des électrodes opposées et les surfaces frontales (16, 20) du cristal (1), chaque fois opposées, dans la direction y ou la direction x, servent de points d'injection ou de découplage de l'onde lumineuse,
caractérisé en ce que

sur chaque surface de plaquette (2, 3) les électrodes (5, 6; 7, 8) de chacune des paires d'électrodes (5, 6; 7, 8) sont prévues dans la direction y ou la direction x en forme de bandes, parallèles, et elles sont distantes l'une de l'autre de la distance (13) pour que chaque fois une paire (5, 6) de ces électrodes soit opposée à l'autre paire (7, 8) de ces électrodes et chaque fois les électrodes (5, 8; 6, 7) diagonalement opposées sont reliées électriquement.

**10.** Capteur selon la revendication 9, caractérisé en ce que le cristal (1) est du niobat de lithium.

FIG.1

FIG.2

FIG.3

FIG.4

FIG.5

FIG.6

FIG.7